# EUROPÄISCHE PATENTANMELDUNG

(11) **EP 0 649 025 A1**
(43) Veröffentlichungstag der Anmeldung: **19.04.1995**
(21) Anmeldenummer: 94115530.1
(22) Anmeldetag: 01.10.1994
(51) Int. Cl.: G01R 11/24

(54) **Statischer Elektrizitätszähler**

(30) Priorität: 15.10.1993 CH 3126/93
(71) Anmelder: ZELLWEGER LUWA AG, CH-8610 Uster (CH)
(72) Erfinder: Christener, Juerg, CH-8610 Uster (CH); Warmerdam, Petrus, CH-8620 Wetzikon (CH)
(74) Vertreter: Ellenberger, Maurice

(57) **Zusammenfassung**

Das Gehäuse des Elektrizitätszählers enthält einen Datenspeicher und eine von aussen zugängliche Schnittstelle zu diesem und ist mit einem durch eine Plombe (11) gesicherten Gehäusedeckel (3) abgeschlossen. Der Datenspeicher ist in Speicherbereiche verschiedener Sicherheitsgrade unterteilt. Für die Speicherbereiche mit einem höheren Sicherheitsgrad besteht erst nach dem Brechen einer Eichplombe und der Vornahme einer zusätzlichen Manipulation eine Zugriffsmöglichkeit.

Die zusätzliche Manipulation besteht im Schliessen eines im Zählerinnern angeordeten Kalibrierkontakts, und die Eichplombe ist durch die Plombe (11) zur Sicherung des Gehäusedeckels (3) gebildet.

## Beschreibung

Die vorliegende Erfindung betrifft einen statischen Elektrizitätszähler mit einem einen Datenspeicher enthaltenden Gehäuse, mit einem dieses abschliessenden und durch eine Plombe gesicherten Gehäusedeckel, und mit einer von aussen zugänglichen Schnittstelle zu dem Datenspeicher.

Die Schnittstelle ist beispielsweise eine erst nach Eingabe eines Passwortes zugängliche optische Schnittstelle am Gehäusedeckel. Die Sicherung durch ein Passwort ist so lange ausreichend, als die betreffenden Daten sicherheitstechnisch nicht kritisch sind, was beispielsweise für den Zählerstand oder die Tarifschaltung zutrifft. In diesen Fällen ist es sogar ausgesprochen vorteilhaft und bedienungsfreundlich, wenn die für den Gebrauch nötigen Einstellungen und die Parametrierung ohne zusätzliche Manipulationen von aussen in die Speicher eingegeben werden können.

Es gibt auch für den Zähler wesentliche und kritische Daten, wie beispielsweise die das Verhältnis zwischen den gemessenen Leistungswerten der Sensoren und dem abgespeicherten und damit zu verrechnenden Energieverbrauch darstellenden Eichwerte, für die ein besserer Zugriffsschutz wünschenswert oder sogar erforderlich ist. Dieser bessere Zugriffsschutz soll aber ohne die Bedienung wesentlich erschwerende Zusatzmanipulationen möglich sein.

Durch die Erfindung soll nun ein statischer Elektrizitätszähler der eingangs genannten Art angegeben werden, bei dem einerseits für bestimmte kritische Daten ein sicherheitstechnisch verbesserter Zugriffsschutz besteht, und bei dem andererseits der Zugriff auf diese kritischen Daten noch immer relativ einfach möglich ist.

Diese Aufgabe wird erfindungsgemäss dadurch gelöst, dass der Datenspeicher in Speicherbereiche verschiedener Sicherheitsgrade unterteilt ist, und dass für den oder die Speicherbereiche mit einem höheren Sicherheitsgrad erst nach dem Brechen einer Eichplombe und der Vornahme einer zusätzlichen Manipulation eine Zugriffsmöglichkeit besteht.

Im folgenden wird die Erfindung anhand eines Ausführungsbeispiels und der Zeichnungen näher erläutert; es zeigen:
- Fig. 1: eine perspektivische Darstellung der Aussenansicht eines Zählers bei geschlossenem Gehäuse,
- Fig. 2: eine Ansicht des Zählers mit offenem Klemmendeckel,
- Fig. 3: eine Ansicht des Zählers mit offenem Gehäusedeckel; und
- Fig. 4: eine Explosionszeichnung zu Fig. 3.

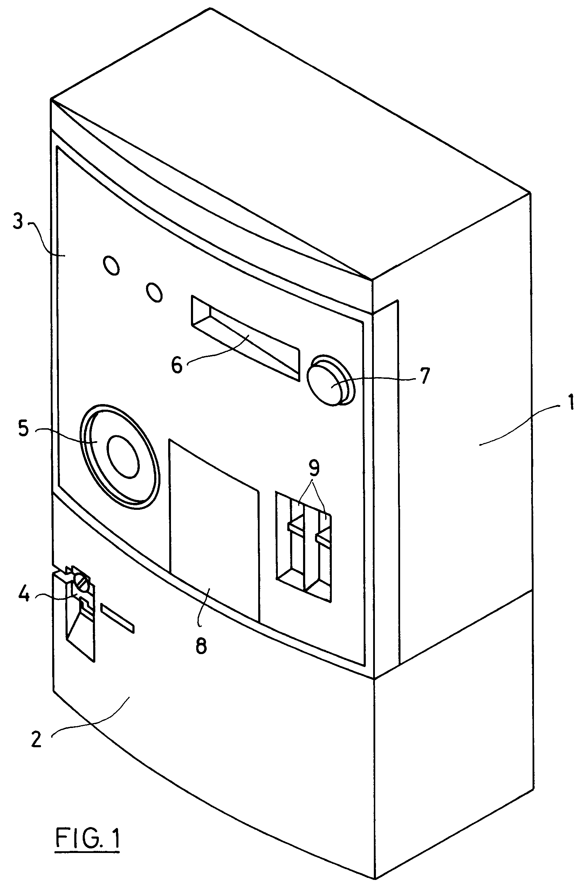

Das in Fig. 1 dargestellte Zählergehäuse besteht im wesentlichen aus einem schachtelartigen Gehäuseboden 1, der in seinem unteren Teil von einem Klemmendeckel 2 und in seinem oberen Teil durch einen Gehäusedeckel 3 abgedeckt ist. Der Klemmendeckel 2 ist durch eine Klemmendeckelplombe 4 gegen unberechtigtes Öffnen gesichert. Wird diese Plombe gebrochen, dann kann der Klemmendeckel 2 geöffnet werden, womit einerseits der Zugang zu den Zählerklemmen und andererseits zu einer den Gehäusedeckel 3 gegen unberechtigtes Öffnen sichernden Gehäusedeckelplombe freigelegt ist.

Wie Fig. 1 weiter zu entnehmen ist, ist am Gehäusedeckel 3 eine optische Schnittstelle 5 für den Zugriff zu einem inneren Datenspeicher des Zählers vorgesehen. Diese Schnittstelle dient zur Parametrierung des Zählers, für die Eingabe von Einstelldaten, zur Programmierung und zur Übertragung des Zählerstandes zur externen Ablesung. Der Zugriff zum inneren Datenspeicher über die Schnittstelle 5 ist nur nach Eingabe eines Passwortes möglich. Ausserdem weist der Gehäusedeckel 1 ein numerisches Anzeigefeld 6, einen Knopf 7 für den Abruf der im Anzeigefeld 6 anzuzeigenden Daten und ein Beschriftungsfeld 8 mit den verschiedenen Einstellungen auf. Beispiele für solche Einstellungen sind die Zuweisungen von Rundsteuerbefehlen zu verschiedenen Zählerregistern.

Diese Zählerregister sind mehrere Tarifregister, die dem im Gehäuse angeordneten Messelement für die verbrauchte elektrische Energie beliebig zugeordnet werden können. Die Tarifschaltung erfolgt vorzugsweise über ein im Gehäuse eingebautes Rundsteuer-Modul, welches ausserdem mit dem Bezugszeichen 9 bezeichnete, optionale, integrierte Lastrelais für die direkte Schaltung von Warmwasserboiler oder anderen Lasten steuern kann.

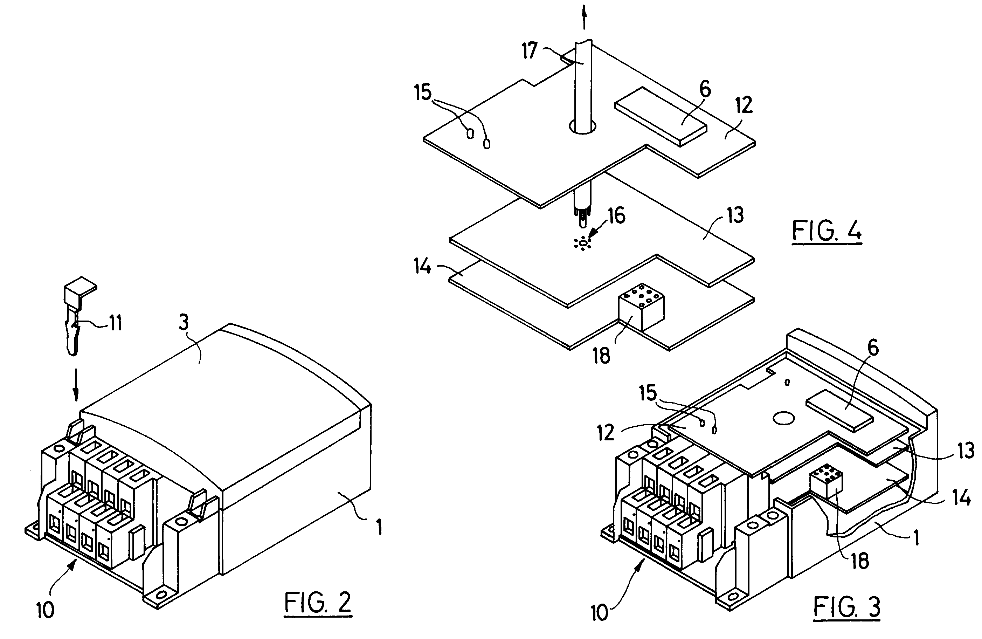

Fig. 2 zeigt den Zähler bei abgenommenem Klemmendeckel 2 (Fig. 1). In diesem Zustand sind die Klemmen 10 des Anschlussteils des Messelements des Zählers frei zugänglich, wobei es sich beim dargestellten Zähler um einen solchen mit einem dreiphasigen Messelement handelt, was aber für die vorliegende Erfindung nicht von Bedeutung ist. Bezüglich des Messelements und der verschiedenen Ausführungen von diesem wird auf die EP-A-0 494 428 und die EP-A-0 546 453 verwiesen.

Wie Fig. 2 weiter zu entnehmen ist, ist bei geöffnetem Klemmendeckel 2 ausserdem die schon erwähnte und mit dem Bezugszeichen 11 bezeichnete Zählerdeckelplombe zugänglich, nach deren Brechen der Gehäusedeckel 3 geöffnet werden kann. Der bessere Übersichtlichkeit halber ist in der Figur die Zählerdeckelplombe 11 vor der Herstellung der Plombierung (Einschieben in Pfeilrichtung) dargestellt.

Gemäss Fig. 3 ist nach dem Öffnen des Gehäusedeckels 3 das Zählerinnere mit der gesamten Mess-, Speicher- und Auswerteelektronik zugänglich. Die genannte Elektronik ist durch drei Leiterplatten 12, 13 und 14 symbolisiert, wobei die Leiterplatte 12 das sogenannte Tarifmodul mit dem Anzeigefeld 6 und Anschlüssen 15 zur Schnittstelle 5 (Fig. 1), die Leiterplatte 13 eine Messplatine mit einer Schnittstelle zu allfälligen Optionsmodulen, und die Leiterplatte 14 die sogenannte Netzteilplatine bezeichnet.

Der Datenspeicher des Zählers ist in Speicherbereiche verschiedener Sicherheitsgrade oder Sicherheitsstufen unterteilt. Beispielsweise sind zwei Sicherheitsgrade, normale und hohe Sicherheit, vorgesehen, von denen die hohe Sicherheit für die Eichwerte des Zählers und die normale Sicherheit für die restlichen Daten vorgesehen ist. Als Zugriffsschutz für die Stufe normale Sicherheit dient ein Passwort; erst nach dessen Eingabe besteht über die optische Schnittstelle 5 eine Zugriffsmöglichkeit zu dem betreffenden Speicherbereich.

Zu dem Speicherbereich der Stufe hohe Sicherheit ist ein Zutritt erst nach Schliessen eines speziellen Kalibrierkontakts möglich. Dieser Kalibrierkontakt, der auf einer der Leiterplatten 12 bis 14 angeordnet ist, ist durch einen Schalter, zwei Gabelstecker mit einem Überbrückungsbügel oder durch eine geeignete Kontaktstelle gebildet.

Gemäss Fig. 4 ist auf der Leiterplatte 13 eine Kontaktstelle 16 angeordnet, die zum Einschieben eines steckerartigen Kontaktorgans 17 vorgesehen ist. Sobald dieses eingeschoben ist, werden zwei der darstellungsgemäss sechs Kontaktstellen miteinander verbunden, wodurch der Kalibrierkontakt geschlossen ist. Diese zwei Kontaktstellen sind von ausen nicht als solche erkennbar. Nach dem Schliessen des Kalibrierkontakts 16 können die für den Speicherbereich der hohen Sicherheitsstufe vorgesehenen Daten über die optische Schnittstelle 5 (Fig. 1) oder direkt über Zugriff auf der Leiterplatte selbst abgelegt oder verändert werden. Die erwähnte direkte Zugriffsmöglichkeit ist in den Fig. 3 und 4 durch eine auf der Leiterplatte 14 angeordnete Schnittstelle 18 angedeutet.

Die Sicherung des Speicherbereichs mit den oder für die Daten von hoher Sicherheit ist also zweistufig:
- Technisch gesehen ist ein Zugriff nur möglich, wenn ein im Zählerinnern vorgesehener Kalibrierkontakt geschlossen oder überbrückt wird, wobei diesem von aussen nicht anzusehen ist, welche Kontaktstellen geschlossen oder überbrückt werden müssen.
- Dieser Zugriff ist nur dann möglich, wenn der Zählerdeckel 3 geöffnet, dessen Plombe 11 (Fig. 2) also verletzt ist. Somit hinterlässt jeder Versuch eines Zugriffs auf den speziell gesicherten Speicherbereich eindeutige und nicht zu beseitigende Spuren, so dass jeder Versuch einer Manipulation der Eichwerte erkannt würde.
- Da die ohnehin vorhandene Plombe des Gehäusedeckels nun sozusagen als Eichplombe verwendet wird, ergeben sich keine zusätzlichen Kosten für die Eichplombe. Ausserdem ist für befugte Personen der Zugriff auf den Speicherbereich mit den Daten von hoher Sicherheit immer noch relativ einfach.

## Patentansprüche

1. Statischer Elektrizitätszähler mit einem einen Datenspeicher enthaltenden Gehäuse, mit einem dieses abschliessenden und durch eine Plombe gesicherten Gehäusedeckel, und mit einer von aussen zugänglichen Schnittstelle zu dem Datenspeicher, dadurch gekennzeichnet, dass der Datenspeicher in Speicherbereiche verschiedener Sicherheitsgrade unterteilt ist, und dass für den oder die Speicherbereiche mit einem höheren Sicherheitsgrad erst nach dem Brechen einer Eichplombe (11) und der Vornahme einer zusätzlichen Manipulation eine Zugriffsmöglichkeit besteht.

2. Elektrizitätszähler nach Anspruch 1, dadurch gekennzeichnet, dass im Zählerinnern ein Kalibrierkontakt (16) vorgesehen ist und dass die zusätzliche Manipulation im Schliessen oder Überbrücken dieses Kalibrierkontaktes besteht.

3. Elektrizitätszähler nach Anspruch 2, dadurch gekennzeichnet, dass der Kalibrierkontakt (16) auf einer Leiterplatte (13) angeordnet ist.

4. Elektrizitätszähler nach Anspruch 3, dadurch gekennzeichnet, dass der Kalibrierkontakt (16) mehr als zwei Kontaktstellen aufweist, von denen zur Überbrückung oder zum Schliessen des Kontakts zwei als solche nicht erkennbare Kontaktstellen miteinander verbunden werden.

5. Elektrizitätszähler nach Anspruch 4, gekennzeichnet durch ein steckerartiges Organ (17) zum Schliessen des Kalibrierkontakts (16).

6. Elektrizitätszähler nach einem der Ansprüche 1 bis 5, dadurch gekennzeichnet, dass die genannte Eichplombe (11) durch die Plombe für den Gehäusedeckel (3) gebildet ist.
